# EUROPEAN PATENT SPECIFICATION

(11) **EP 3 489 385 B1**
(45) Date of publication and mention of the grant of the patent: **28.07.2021**
(21) Application number: 17858057.7
(22) Date of filing: 02.08.2017
(51) Int. Cl.: C23C 18/16, C23C 18/18, C23C 18/44, H05K 3/24

(54) **ELECTROLESS PALLADIUM/GOLD PLATING PROCESS**
STROMLOSES PALLADIUM/GOLD-PLATTIERUNGSVERFAHREN
PROCÉDÉ DE PLACAGE PALLADIUM/OR AUTOCATALYTIQUE

(30) Priority: 05.10.2016 JP 2016197257
(43) Date of publication of application: 29.05.2019
(73) Proprietor: Kojima Chemicals Co. Ltd., Sayama-shi, Saitama 350-1335 (JP)
(72) Inventor: KATO, Tomohito, Sayama-shi Saitama 350-1335 (JP); WATANABE, Hideto, Sayama-shi Saitama 350-1335 (JP)
(74) Representative: Vossius & Partner Patentanwälte Rechtsanwälte mbB
(86) International application number: PCT/JP2017/028027
(87) International publication number: WO 2018/066217

(56) References cited:
- EP-A1- 2 910 666
- WO-A1-2010/004856
- JP-A- H0 711 448
- JP-A- H05 327 187
- JP-A- 2005 317 729
- US-A1- 2013 058 062

## Description

### [Technical Field]

The present invention relates to an electroless palladium/gold plating process for forming a palladium plating film on copper and subsequently forming a gold plating film by electroless plating treatments.

### [Background Art]

Conventionally, as a process for forming a nickel plating film on copper of a copper electrode, a copper wiring and the like in an electronic substrate having independent electrodes or independent wirings, and forming a gold plating film on the nickel plating film,
an electroless nickel/gold plating process is carried out. In an electroless nickel/gold plating process, a nickel plating film is formed with a thickness of 3 µm or more in order to prevent diffusion of copper into a gold surface, and a gold plating film is formed with a thickness of 0.03 µm or more in order to obtain stable implementation properties.

In recent years, densification of electronic circuitry has proceeded, and it is required to narrow line/space (hereinafter, referred to as "L/S") to be a few tens of micrometers or less, even 10 µm or less. In a case where L/S is a few tens of micrometers or less, for example in the case of L/S = 30 µm /30 µm, when a nickel plating film of 3 µm is formed by an electroless nickel plating treatment, nickel abnormally precipitates between the wirings, and causes a short circuit in electronic circuitry. Therefore, nickel precipitation between the wirings is prevented by reducing plating time by the electroless nickel plating treatment so that thickness of nickel plating film is 1 µm or less.

Nevertheless, in a case where the thickness of the nickel plating film is 1 µm or less, when a subsequent electroless gold plating treatment is carried out, a portion of the nickel plating film corrodes, and pinholes that run through the film may occur (nickel local corrosion phenomenon). A problem is that depending on the state of the pinholes, copper or nickel diffuses into the gold plating film surface through the pinhole to produce oxides of copper or oxides of nickel, and implementation failure at the time of solder implementation or wire bonding implementation easily occurs.

Therefore, in order to prevent the generation of the above-described nickel local corrosion phenomenon, it is considered that by performing an electroless nickel/palladium/gold plating process disclosed in, for example, Patent Document 1, a palladium plating film with a thickness of 0.03 µm or more is formed on a nickel plating film with a thickness of 1 µm or less, and subsequently, a gold plating film with a thickness of 0.03 µm or more is formed.

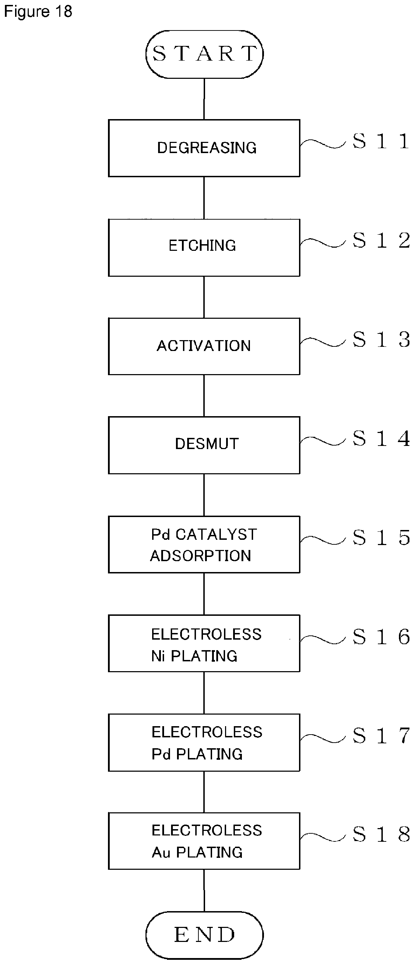

In the electroless nickel/palladium/gold plating process, as shown in Figure 18, first of all, a degreasing treatment (step (hereinafter, referred to as "S") 11) of the insulating base material with a surface on which the copper has been disposed is carried out.
The degreasing treatment (S11) is usually carried out by immersing the insulating base material in an acidic solution of which main components are an inorganic acid, an organic acid, and a surfactant. Next, an etching treatment (S12) of the insulating base material subjected to the degreasing treatment (S11) is carried out to remove the oxide film on the copper. The etching treatment (S12) is usually carried out by immersing the insulating base material in a mixed solution of persulfuric acid salt and sulfuric acid, a mixed solution of aqueous hydrogen peroxide and sulfuric acid, or the like. Subsequently, an activation treatment (S13) and a desmutting treatment (S14) is carried out, although this is not described in Patent Document 1.

Next, a palladium catalyst adsorption treatment (S15) of the insulating base material subjected to the desmutting treatment (S14) is carried out to adsorb a palladium catalyst to the copper surface. The palladium catalyst adsorption treatment is carried out by immersing the insulating base material in a solution including a palladium compound (hereinafter, referred to as "palladium catalyst-containing solution"). When the subsequent electroless nickel plating process (S16) is carried out, nickel precipitation does not proceed without acting palladium as a catalyst to the copper surface, and therefore, the palladium catalyst adsorption treatment is usually considered to be essential.

Next, an electroless nickel plating treatment (S16), an electroless palladium plating treatment (S17) and an electroless gold plating treatment (S18) of the insulating base material subjected to the palladium catalyst adsorption treatment are carried out. As a result, a nickel plating film, a palladium plating film and a gold plating film are sequentially formed on the copper of the insulating base material.

Such an electroless nickel/palladium/gold plating process is also known from Patent Document 2, which additionally discloses a step of selectively removing the palladium catalyst using a sulfur-containing aqueous solution after the palladium catalyst adsorption treatment.

However, in the case of further narrowing L/S to be 10 µm or less, for example in the case of L/S = 8 µm/8 µm, when a nickel plating film of 1 µm is formed by an electroless nickel plating treatment, nickel abnormally precipitates between the wirings. In this case, a problem is that palladium and gold also precipitate on the abnormally precipitated nickel, and electronic circuitry undergoes a short circuit.

Therefore, it is envisioned to form a palladium plating film and a gold plating film directly on copper without formation of a nickel plating film. In other words, an electroless palladium/gold plating process in which processes in which an electroless nickel plating treatment (S16) is not carried out among electroless nickel/palladium/gold plating processes shown in Figure 18, that is to say, S11 to S15 and S17 to S18 is carried out is envisioned.

### [Citation List]

### [Patent Document]

[Patent Document 1] Japanese Patent Laid-Open No. 2014-185398
[Patent Document 2] US Patent Application No. 2013/0058062 A1

### [Summary of Invention]

### [Technical Problem]

However, there are following disadvantages with regard to the above-described electroless palladium/gold plating process. (1) In a case where an electrode disposed on a surface of an insulating base material is a single electrode in which an independent wiring makes electrons unlikely to flow, and where the single electrode is compact sized, when the palladium catalyst adsorption treatment (S15) is carried out, palladium is unlikely to adhere to a surface of the compact sized single electrode. In this case, when an electroless palladium plating treatment (S17) is subsequently carried out, palladium precipitation reaction is unlikely to proceed in this compact sized single electrode, and abnormal palladium precipitation, i.e., no precipitation of palladium, coarsening of the palladium crystals, or heterogeneous precipitation, occurs. As a result, in the palladium plating coating film-formed by the electroless palladium plating treatment, pinholes that run through the coating easily occur. In a case where pinholes are present in the palladium plating coating, depending on the state of the pinholes, failure of forming the gold plating may occur in a subsequent electroless gold plating treatment.

(2) After formation of the palladium/gold plating film, electronic components are incorporated by solder implementation, and at this time, the palladium/gold plating film is heated. In a case where the above-described pinholes are present in the palladium plating film, depending on the state of the pinholes, cupper diffuses into the gold plating film surface through the pinholes to produce oxides of copper, and may result in decrease in the wire bonding properties.

It is an object of the present invention to provide an electroless palladium/gold plating process that can form a palladium/gold plating film selectively only on the copper without generating abnormal palladium precipitation even in a case where cupper is a compact sized single electrode or a wiring with a narrow L/S.

### [Solution to Problem]

As a result of a diligent study, the inventors of the present application have found that by allowing a sulfur compound to be adsorbed on a copper surface to adjust a surface electric potential of copper, a palladium/gold plating film can be formed selectively only on the copper.

In other words, the present invention comprises an electroless palladium/gold plating process for forming a palladium plating film directly on copper of an insulating base material with a surface on which the copper has been disposed and subsequently forming a gold plating film, by electroless plating treatments, comprising: a step of carrying out a copper surface electric potential adjusting treatment by immersing the insulating base material with a surface on which the copper has been disposed in a sulfur-containing aqueous solution containing one or more sulfur compounds selected from the group consisting of a thiosulfuric acid salt and a thiol; a step of carrying out an electroless palladium plating treatment by immersing the insulating base material in which the surface electric potential of the copper has been adjusted in an electroless palladium plating solution to form a palladium plating film directly on the copper;
and a step of carrying out an electroless gold plating treatment by immersing the insulating base material in which the palladium plating film has been formed directly on the copper in an electroless gold plating solution to form a gold plating film on the palladium plating film.

It is preferable that the thiosulfuric acid salt be sodium thiosulfate or potassium thiosulfate.

It is preferable that the thiol be one or more selected form a group consisting of thiomalic acid, thiouracil and thiourea.

It is preferable that the sulfur-containing aqueous solution contain a palladium compound at a concentration range of 10 mg/L or less.

It is preferable that the electroless palladium/gold plating process comprise, before the step of carrying out a surface electric potential adjusting treatment, a step of carrying out a degreasing treatment by immersing the insulating base material with a surface on which the copper has been disposed in a neutral degreasing solution, wherein the neutral degreasing solution contain 20 to 40 g/L of thiodiglycolic acid, 1 to 5 g/L of sodium gluconate, and 0.05 to 0.1 g/L of a nonionic surfactant, and pH of the neutral degreasing solution be 5.0 to 7.0.

It is preferable that the electroless palladium/gold plating process comprise, before the step of carrying out a surface electric potential adjusting treatment, a step of carrying out a copper oxide film removing treatment by immersing the insulating base material with a surface on which the copper has been disposed in a copper oxide film removing solution, wherein the copper oxide film removing solution contain 2.5 to 12.5 g/L of thioglycol and 1.25 to 2.5 g/L of a nonionic surfactant, and pH of the copper oxide film removing solution be 5.0 to 7.0.

In the electroless palladium/gold plating process, it is preferable that the electroless palladium plating treatment be carried out by reduction type plating.

In the electroless palladium/gold plating process, it is preferable that the electroless gold plating treatment be carried out by a reduction type plating.

### [Advantageous Effects of Invention]

In the electroless palladium/gold plating process of the present invention, due to the fact that the sulfur compound is adsorbed on the copper surface by the copper surface electric potential adjusting treatment, a surface electric potential of the copper is adjusted to be an electric potential that leads to easy precipitation of palladium. Therefore, in the case of subsequent electroless palladium plating treatment, it is possible to precipitate a palladium nucleus only on the copper. As a result, according to the electroless palladium/gold plating process, it is possible to form a palladium/gold plating film selectively only on the copper without formation of the plating film on the insulating base material.

In addition, even in a case where copper is a compact sized single electrode or a wiring with a narrow L/S, due to the fact that the surface electric potential of the copper is reliably adjusted by the adsorption of the sulfur compound, a palladium/gold plating film can be reliably formed on the copper without the occurrence of abnormal palladium precipitation in the case of the electroless palladium plating treatment.

### [Brief Description of Drawings]

[Figure 1] Figure 1 is a flow chart showing an electroless palladium/gold plating process of the present embodiment.
[Figure 2] Figure 2 is a SEM image of a copper surface before being subjected to a degreasing step.
[Figure 3] Figure 3 is a SEM image of a copper surface after being subjected to a degreasing step using an acidic solution.
[Figure 4] Figure 4 is a SEM image of a copper surface after being subjected to a degreasing step using a neutral degreasing solution.
[Figure 5] Figure 5 is a graph showing AFM analysis results of a copper surface before being subjected to a copper oxide film removing step.
[Figure 6] Figure 6 is a graph showing AFM analysis results of a copper surface after being subjected to a copper oxide film removing step using a sulfuric acid mixed solution.
[Figure 7] Figure 7 is a SEM image of a copper surface after being subjected to a copper oxide film removing step using a copper oxide film removing solution.
[Figure 8] Figure 8 is a SEM image of a palladium plating film surface subjected to an electroless palladium plating step after a palladium catalyst adsorption treatment.
[Figure 9] Figure 9 is a SEM image of a palladium plating film surface subjected to an electroless palladium plating step after a copper surface electric potential adjusting step.
[Figure 10] Figure 10 is a SEM image of a cross section of a palladium plating film subjected to an electroless palladium plating step after a copper surface electric potential adjusting step.
[Figure 11] Figure 11 is a graph showing the surface elemental analysis results of the palladium plating film subjected to an electroless palladium plating step after a copper surface electric potential adjusting step.
[Figure 12] Figure 12 is a graph showing the depth direction analysis results of the palladium plating film subjected to an electroless palladium plating step after a copper surface electric potential adjusting step.
[Figure 13] Figure 13 is a SEM image of a surface of a palladium/gold plating film obtained in a process of Example 3.
[Figure 14] Figure 14 is a SEM image of a surface of a nickel/palladium/gold plating film obtained in a process of Reference Example 2.
[Figure 15] Figure 15 is a graph showing a wire bonding strength in a case where gold wires are connected to the plating films obtained by processes of Example 3, Reference Example 1 and Reference Example 2.
[Figure 16] Figure 16 is a graph showing a wire bonding strength in a case where silver wires are connected to the plating films obtained by the processes of Example 3, Reference Example 1 and Reference Example 2.
[Figure 17] Figure 17 is a graph showing a wire bonding strength in a case where copper wires are connected to the plating films obtained by the processes of Example 3, Reference Example 1 and Reference Example 2.
[Figure 18] Figure 18 is a flow chart showing an electroless nickel/palladium/gold plating process of prior art.

### [Description of Embodiments]

Hereinafter, embodiments of an electroless palladium/gold plating process according to the present invention will be described. The electroless palladium/gold plating process of the present embodiment is a process for forming a palladium plating film directly on copper of an electrode, an wiring or the like disposed on a surface of an insulating base material made of an insulation resin, for example epoxy resin, and phenol resin, and in addition, forming a gold plating film on the palladium plating film.

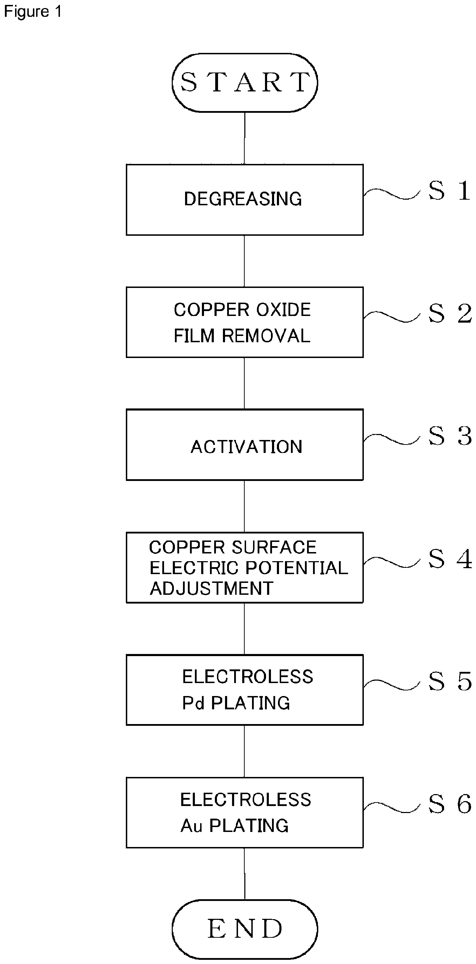

As shown in a flow chart of Figure 1, an electroless palladium/gold plating process comprises a degreasing step (step (S1)), a copper oxide film removing step (S2), an activation step (S3), a copper surface electric potential adjusting step (S4), an electroless palladium (Pd) plating step (S5), and an electroless gold (Au) plating step (S6). Hereinafter, each of these steps will be described. Water washing and drying may be carried out between these steps as needed. In addition, after the electroless palladium plating step (S5) and the electroless gold plating step (S6), a heat treatment may be carried out as needed.

### 1. Degreasing step (S1)

In a degreasing step (S1), oils and fats adhering to a surface of copper or an insulating base material are removed. The degreasing step (S1) can also be carried out using an acidic solution as is a conventional electroless palladium/gold plating process; however, it is preferable to use a neutral degreasing solution in order to suppress the occurrence of roughness on a copper surface. The above-described neutral degreasing solution is an aqueous solution that contains 20 to 40 g/L of thiodiglycolic acid, 1 to 5 g/L of sodium gluconate, and 0.05 to 0.1 g/L of a nonionic surfactant, and of which pH is 5.0 to 7.0. The degreasing step (S1) can be carried out, for example, by immersing the insulating base material with a surface on which the copper has been disposed in the above-described neutral degreasing solution at a temperature of 30 to 50°C for 1 to 10 minutes.

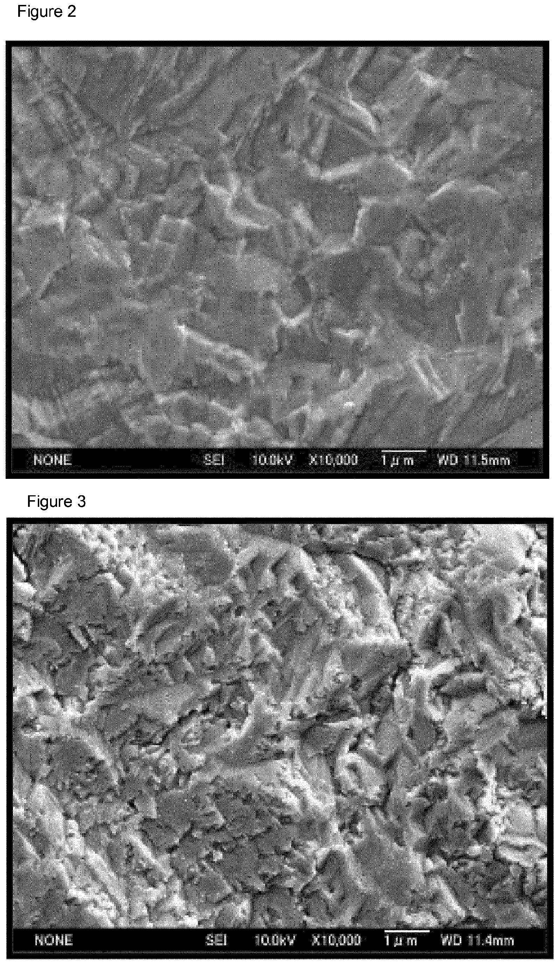

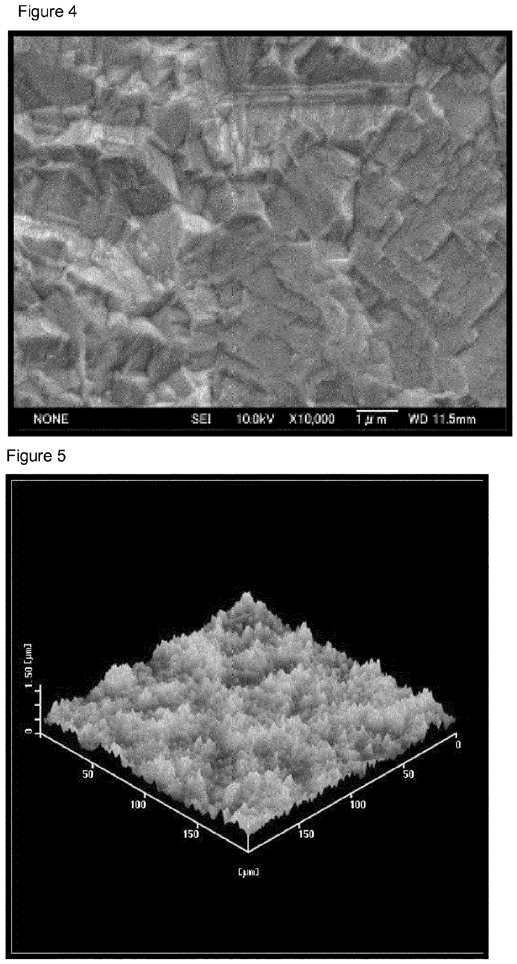

Figure 2 is a SEM image (magnification of 10 thousand times) of a copper surface before being subjected to the degreasing step (S1) observed by an field-emission type scanning electron microscope (FE-SEM), and Figure 3 is a SEM image (magnification of 10 thousand times) by observation of a copper surface after being subjected to a degreasing step (S1) using an acidic solution used in a plating process of prior art, and Figure 4 a SEM image (magnification of 10 thousand times) by observation of a copper surface after being subjected to a degreasing step (S1) using the above-described neutral degreasing solution. As the above-described acidic solution, an aqueous solution that contained 20 to 40 g/L of thiodiglycolic acid, 1 to 5 g/L of phosphoric acid, and 0.05 to 0.1 g/L of a nonionic surfactant, and of which pH was from 0.5 to 1.0 was used.

When compared to the copper surface before being subjected to the degreasing step (S1) shown in Figure 1, it is obvious from Figure 3 that according to the degreasing step (S1) using the above-described acidic solution, roughness has occurred on the copper surface. In view of this fact, it is considered that copper has been heterogeneously dissolved on the surface of the copper film. In a case where such roughness has occurred on a copper surface, the film formability of the film in the subsequent electroless palladium plating step (S5) or the electroless gold plating step (S6) may be influenced. On the other hand, it is obvious from Figure 4 that according to the degreasing step (S2) using the above-described neutral degreasing solution, there is no major change in the surface state when compared to the copper surface before being subjected to the degreasing step (S1) shown in Figure 1, and roughness has not occurred on the copper surface. Therefore, in the degreasing step (S2), it is obvious that use of the above-described neutral degreasing solution is more preferable than use of the above-described acidic solution.

### 2. Copper oxide film removing step (S2)

In a copper oxide film removing step (S2), a copper oxide film covering the copper surface is removed. The copper oxide film removing step (S2) can also be carried out using a mixed solution of persulfuric acid salt and sulfuric acid as well as a mixed solution of aqueous hydrogen peroxide and sulfuric acid as is a conventional electroless palladium/gold plating process; however, not only the copper oxide film is removed, but also roughness may occur on the copper surface by elution of copper itself. Therefore, in the copper oxide film removing step (S2), it is preferable to use a copper oxide film removing solution that can remove a copper oxide film without elution of copper. The above-described copper oxide film removing solution is an aqueous solution that contains 2.5 to 12.5 g/L of thioglycol and 1.25 to 2.5 g/L of a nonionic surfactant, and of which pH is 5.0 to 7.0. The copper oxide film removing step (S2) can be carried out, for example, by immersing the insulating base material subjected to degreasing in the above-described copper oxide film removing solution approximately at a room temperature for 30 seconds to 5 minutes.

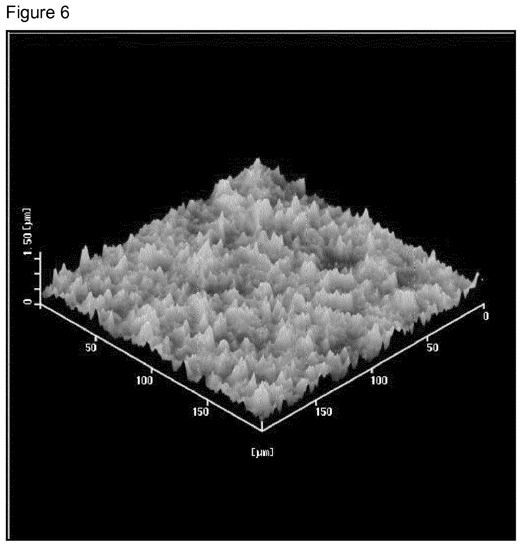

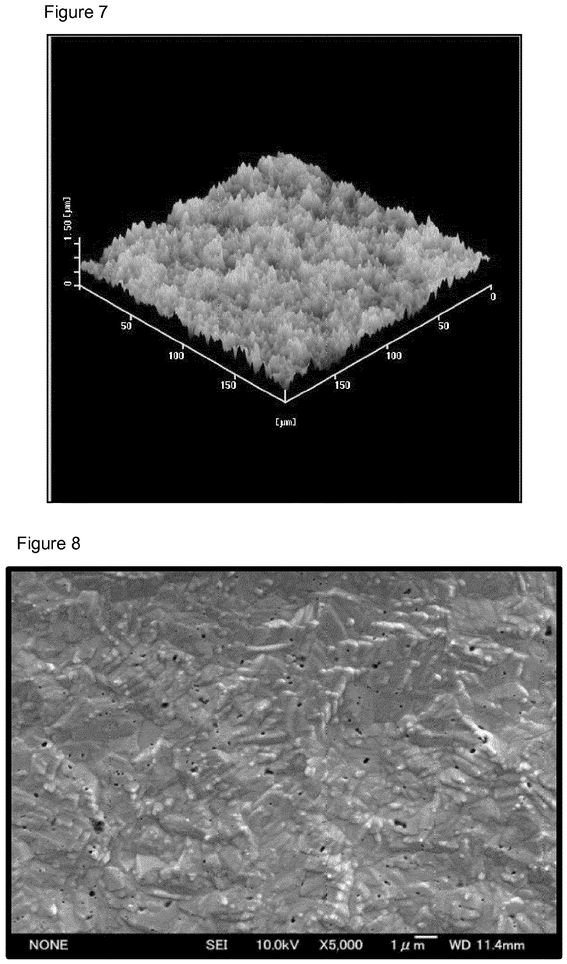

Figure 5 is an AFM image by observation of a copper surface before being subjected to the copper oxide film removing step (S2) with an atomic force microscope (AFM), and Figure 6 is an AFM image by observation of a copper surface after being subjected to a copper oxide film removing step (S2) using a sulfuric acid mixed solution used in a plating process of prior art, and Figure 7 is an AFM image by observation of the copper surface after being subjected to a copper oxide film removing step (S2) using the above-described copper oxide film removing solution. As the above-described sulfuric acid mixed solution, an aqueous solution that included 125 g/L of sodium persulfate and 18.4 g/L of sulfuric acid, and of which pH was from 0.5 to 0.8 was used.

It is obvious from Figure 6 that according to the copper oxide film removing step (S2) using the above-described sulfuric acid mixed solution, when compared to the copper surface before being subjected to the copper oxide film removing step (S2) shown in Figure 5, unevenness on the copper surface have become larger, and roughness has occurred on the copper surface. It is considered that copper on the surface of the copper film has been heterogeneously dissolved. By contrast to this, it is obvious from Figure 7 that according to the copper oxide film removing step (S2) using the above-described copper oxide film removing solution, there is no major change in the surface state when compared to the copper surface before being subjected to the copper oxide film removing step (S2) shown in Figure 5, and roughness has not occurred on the copper surface. Therefore, in the copper oxide film removing step (S2), it is obvious that use of the above-described copper oxide film removing solution is more preferable than use of the mixed solution including the above-described sulfuric acid.

### 3. Activation step (S3)

In an activation step (S3), smut and the like adhering to a copper surface is removed by immersing the insulating base material from which the copper oxide film has been removed in a sulfuric acid solution at a concentration of 5 to 10 wt%. The smut is a black substance in the form of a fine powder that has resulted from the above-described copper oxide film removing step. The activation step (S3) can be carried out, for example, by immersing the insulating base material in a sulfuric acid solution at a room temperature for 30 seconds to 5 minutes.

### 4. Copper surface electric potential adjusting step (S4)

In a copper surface electric potential adjusting step (S4), the sulfur compound is adhered to the copper surface by immersing the activated insulating base material in a sulfur-containing aqueous solution, and thus, the surface electric potential of the copper is adjusted. The above-described sulfur-containing aqueous solution contains one or more sulfur compounds selected from the group consisting of a thiosulfuric acid salt and a thiol. The thiosulfuric acid salt is sodium thiosulfate or potassium thiosulfate. The thiol is one or more selected from the group consisting of thiomalic acid, thiouracil and thiourea.

The copper surface electric potential adjusting step (S4) is carried out by immersing the above-described activated insulating base material in the above-described sulfur-containing aqueous solution, for example at a temperature of 40 to 80°C for 30 seconds to 10 minutes. When the above-described activated insulating base material is immersed in the above-described sulfur-containing aqueous solution, the sulfur compound included in the above-described sulfur-containing aqueous solution is adsorbed on the copper surface, and the copper surface electric potential is adjusted to be an electric potential that leads to easy precipitation of palladium in the subsequent electroless palladium plating step (S5).

It is preferable that the sulfur-containing aqueous solution contain the above-described sulfur compound in a range of from 0.001 mol/L or more to 0.1 mol/L or less. By setting the content of the above-described sulfur compound to be 0.001 mol/L or more, the above-described sulfur compound can be reliably adsorbed on the copper surface, even in a case where a plating target is a compact sized single electrode or a wiring with a narrow L/S. In addition, it is not possible to obtain a further effect even in a case where the content of the above-described sulfur compound exceeds 0.1 mol/L. With regard to sulfur-containing aqueous solution, it is further preferable that the content of the above-described sulfur compound is in a range of from 0.005 mol/L or more to 0.05 mol/L or less, and by setting the content to be in this range, it is possible to carry out the above-described surface electric potential adjustment reliably.

The above-described sulfur-containing aqueous solution can include various components such as a complexing agent and a pH modifier in addition to the above-described sulfur compound.

As a complexing agent, it is possible to use conventionally known various complexing agents, in addition to ethylenediaminetetraacetic acid dipotassium and malonic acid. In the case of using ethylenediaminetetraacetic acid dipotassium as a complexing agent, it is preferable that the content of ethylenediaminetetraacetic acid dipotassium in a plating pretreatment solution be in a range of from 0.01 mol/L or more to 1 mol/L or less. In the case of using malonic acid as a complexing agent, it is preferable that the content of malonic acid in the sulfur-containing aqueous solution be in a range of from 0.01 mol/L or more to 0.1 mol/L or less. In the case of using ethylenediaminetetraacetic acid dipotassium or malonic acid as a complexing agent, it is possible to improve an appearance or a color tone of palladium plating film in the subsequent electroless palladium plating step (S5).

As a pH modifier, it is possible to use conventionally known various pH modifier. It is preferable that the sulfur-containing aqueous solution be adjusted to be a pH in a range of 4 to 8 by addition of a pH modifier, and it is more preferable that pH of the sulfur-containing aqueous solution be from 6.5 to 7.5. By adjusting pH of sulfur-containing aqueous solution to be in the above-described range, it is possible to carry out the above-described surface electric potential adjustment reliably.

### 5. Electroless palladium plating step (S5)

Next, in an electroless palladium plating step, an electroless palladium plating treatment is carried out by immersing the insulating base material in which the surface electric potential of the copper has been adjusted in an electroless palladium plating solution to form a palladium plating film on the copper. When the electroless palladium plating treatment is a displacement plating, the copper surface becomes rough due to elution of copper, and it is therefore preferable that the electroless palladium plating treatment be carried out by a reduction type plating (autocatalyst type plating).

In the case of carrying out the reduction type electroless palladium plating treatment, it is possible to use an electroless palladium plating solution including water soluble palladium compound, ethylene diamine, sodium formate as a reducing agent, and ethylenediaminetetraacetic acid dipotassium as a chelating agent, for example.

The electroless palladium plating step (S5) is carried out by immersing the above-described insulating base material in which the surface electric potential of the copper has been adjusted in the above-described electroless palladium plating solution, for example at a temperature of 50 to 90°C with a pH of 4 to 6, and it is possible to adjust the film thickness of the palladium plating film by the immersion time. In the above-described insulating base material immersed in the electroless palladium plating solution, the surface electric potential of the copper has been adjusted by the copper surface electric potential adjusting step (S4) to be an electric potential that leads to easy precipitation of palladium, and it is therefore possible to precipitate palladium selectively only on the copper surface to form a palladium plating film.

In addition, due to the fact that copper elution has been suppressed in the copper surface electric potential adjusting step (S4), when the electroless palladium plating step (S5) is carried out, it is possible to suppress the occurrence of pinholes or voids in the palladium plating film formed on the copper.

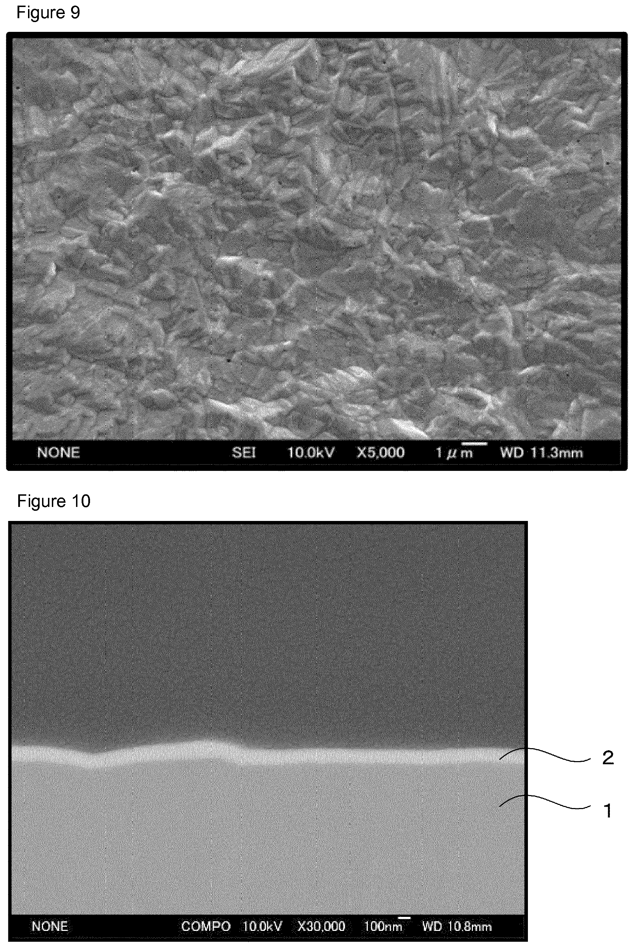

Figure 8 is an SEM image (magnification of 5000 times) observed by FE-SEM of a surface of a palladium plating film formed on copper by being subjected to the electroless palladium plating step (S5) after the palladium catalyst adsorption treatment (S15). It is obvious from Figure 8 that many pinholes have occurred on the palladium plating film, and hole diameter of the pinhole is large. By contrast to this, Figure 9 is a SEM image (magnification of 5000 times) by observation of a surface of the palladium plating film formed on the copper by being subjected to the electroless palladium plating step (S5) after the copper surface electric potential adjusting step (S4), and Figure 10 is a SEM image (magnification of 30 thousand times) by observation of a cross section thereof. It is obvious from Figure 9 and Figure 10 that pinholes occurring in a palladium plating film 2 formed on copper 1 is in a very small number, and in addition, the hole diameter is smaller than that of the pinholes observed in Figure 8.

In addition, even in a case where surface area of the copper is narrow, for example as in a compact sized single electrode or a wiring with a narrow L/S, the surface electric potential of the copper has been adjusted by adhesion of the sulfur compound to the copper surface of the sulfur compound to be an electric potential that leads to easy precipitation of palladium, and therefore, abnormal palladium precipitation does not generate, and it is possible to form a palladium plating film on the copper reliably.

### 6. Electroless gold plating step (S6)

Next, in an electroless gold plating step, an electroless gold plating treatment is carried out by immersing the insulating base material in which the palladium plating film has been formed on the copper in an electroless gold plating solution, and a gold plating film is formed on the palladium plating film. When the electroless gold plating treatment is a displacement plating, the palladium plating film surface becomes rough due to elution of palladium, and it is therefore preferable that the electroless gold plating treatment be carried out by a reduction type plating (autocatalyst type plating).

In the case of carrying out the reduction type electroless gold plating treatment, it is possible to use an electroless gold plating solution that includes a water soluble gold compound, citric acid or a salt thereof, ethylenediaminetetraacetic acid or a salt thereof, hexamethylenetetramine as a reducing agent, as well as a chain polyamine having an alkyl group having 3 or more carbon atoms and 3 or more amino groups, for example.

The electroless gold plating step is carried out by immersing the insulating base material in which the palladium plating film has been formed on the copper in the above-described electroless gold plating solution, for example at a temperature of 40 to 90°C with a pH of 7.5 to 9.0, and it is possible to adjust the film thickness of the gold plating film by the immersion time. In the above-described insulating base material immersed in the electroless gold plating solution, it is possible to precipitate gold selectively only on palladium plating film surface formed on the copper to form a gold plating film. At this time, due to the fact that the palladium plating film has not been formed on the insulating base material, the gold plating film is not formed on the insulating base material.

As described above, according to an electroless palladium/gold plating process of the present embodiment, the surface electric potential of the copper is adjusted by the surface electric potential adjusting step (S4) to be an electric potential that leads to easy precipitation of palladium. As a result, in the electroless palladium plating step (S5), it is possible to form the palladium plating film selectively only on the copper without forming of the palladium plating film on the insulating base material. Thereafter, when the electroless gold plating step (S6) is carried out, as a result, it is possible to form the palladium/gold plating film selectively only on the copper, and it is possible to prevent formation of a palladium plating film or a gold plating film on the insulating base material.

Therefore, for example by carrying out an electroless palladium/gold plating process of the present embodiment on a copper wiring with L/S = 10 µm/10 µm disposed on the insulating base material, it is possible to form the palladium/gold plating film selectively only on the copper wiring without a palladium plating film or a gold plating film being formed on the insulating base material, and it is therefore possible to prevent a short circuit between the copper wirings. In other words, according to an electroless palladium/gold plating process of the present embodiment, even in a case where a plating target is a compact sized single electrode or a wiring with a narrow L/S, it is possible to form a palladium/gold plating film selectively only on the copper without the plating film being formed on the insulating base material.

In addition, in the electroless palladium/gold plating process of the present embodiment, the surface electric potential of the copper is adjusted by the surface electric potential adjusting step (S4) to be an electric potential that leads to easy precipitation of palladium, and therefore even in a case where a plating target is a compact sized single electrode or a wiring with a narrow L/S, abnormal palladium precipitation does not generate, and it is possible to form a palladium/gold plating film reliably.

In addition, in an electroless palladium/gold plating process of the present embodiment, due to the fact that copper elution is suppressed in each step of S1 to S4, it is possible in the electroless palladium plating step (S5) to obtain a palladium plating film with a very small number of pinholes or voids.

In addition, the sulfur-containing aqueous solution used in the surface electric potential adjusting step (S4) may further include a substance that can act as a catalyst in the subsequent electroless palladium plating step (S5), and for example, may include a palladium compound. As the above-described palladium compounds, mention can be made to palladium compounds such as palladium chloride, palladium sulfate, palladium bromide, palladium acetate, and palladium nitrate.

In the case of using a sulfur-containing aqueous solution including a palladium compound in a surface electric potential adjusting step, when the above-described activated insulating base material is immersed in the sulfur-containing aqueous solution, palladium resulting from the palladium compound included in the above-described sulfur-containing aqueous solution selectively adhere to a copper surface. This is due to the fact that in the electroless palladium plating step (S5), the surface electric potential of the copper is adjusted by adsorption on the copper surface of the sulfur compound to be an electric potential that leads to easy precipitation of palladium. Thereafter, when the electroless palladium plating step (S5) is carried out, it is possible, using the palladium catalyst adhered on the copper surface as a nucleus, to precipitate palladium selectively only on the copper surface to form a palladium plating film. Therefore, in a case where a palladium compound is added to the sulfur-containing aqueous solution, it is possible by a subsequent plating treatment to form a palladium/gold plating film selectively only on the copper even in a case where a plating target is a very fine copper wiring such as L/S=30 µm /30 µm or an extremely small sized single electrode made of cupper such as 0.5 mm-square.

In a case where the sulfur-containing aqueous solution contains the above-described palladium compound, it is preferable that the content of the above-described palladium compound be 10 mg/L or less. Although an effect of the palladium compound can be obtained even in a case where the content of the palladium compound is in a trace amount, when the content of the palladium compound exceeds 10 mg/L, copper may be eluted with adhesion of palladium to copper, as described above.

Hereinafter, the present invention will be specifically described on the basis of Examples and the like.

### [Example 1]

In the present Example, among electroless palladium/gold plating processes of the present embodiment, by carrying out a degreasing step (S1), a copper oxide film removing step (S2), an activation step (S3), a copper surface electric potential adjusting step (S4) and an electroless palladium plating step (S5) on a insulating base material on which a copper electrode (single electrode) with any of various sizes of 0.5 to 4 mm-square has been disposed, a palladium plating film was formed on the copper electrode. In the degreasing step (S1), the above-described neutral degreasing solution was used. In the copper oxide film removing step (S2), the above-described copper oxide film removing solution was used. In the surface electric potential adjusting step (S4), the above-described sulfur-containing aqueous solution not containing a palladium compound was used. In the electroless palladium plating step (S5), a palladium plating film with a thickness of 0.1 µm was formed, and subsequently, subjected to a heat treatment at a temperature of 175°C for 4 hours.

### [Example 2]

In the present Example, just as in Example 1, each of the above-described steps S1 to S5 were carried out, except that a sulfur-containing aqueous solution containing 10 mg/L of palladium compound was used in the surface electric potential adjusting step (S4).

### [Comparative Example 1]

In the present Comparative Example, among the electroless palladium/gold plating processes of prior art, each of treatments in S11 to S15 and S17 was sequentially carried out. In the degreasing treatment (S11), the above-described acidic solution was used. In the etching treatment (S12), a mixed solution of 3, 3'-dithiobis(1-propanesulfonic acid sodium) and sulfuric acid was used. In the palladium catalyst adsorption treatment (S15), a palladium catalyst-containing solution including 30 mg/L of a palladium compound and sulfate ions was used. The electroless palladium plating treatment (S17) was carried out as was the electroless palladium plating step (S5) of Example 1.

### <Evaluation>

By visually observing film properties of the respective palladium plating films obtained by the electroless palladium/gold plating processes of Examples 1 and 2, and Comparative Example 1 with a metal microscope, the palladium plating film was determined whether the palladium plating film was good or poor. The results are shown in Table 1. Assessment criteria in Table 1 are as follows.
Good ... the entire electrode is completely covered.
Poor ... there is a portion not covered.

**[Table 1]**

| | electrode size | | | | |
|---|---|---|---|---|---|
| | 0.5 mm-square | 1 mm-square | 2 mm-square | 3 mm-square | 4 mm-square |
| Example 1 | Good | Good | Good | Good | Good |
| Example 2 | Good | Good | Good | Good | Good |
| Comparative Example 1 | Poor | Good | Good | Good | Good |

As shown in Table 1, it is obvious that according to processes of Example 1 and 2, a good palladium plating film was able to be formed in any cases where the size of the copper electrode was from 0.5 mm-square to 4 mm-square. On the other hand, it is obvious that according to a process of Comparative Example 1, the palladium plating film was not able to be formed to the copper electrode of 0.5 mm-square well.

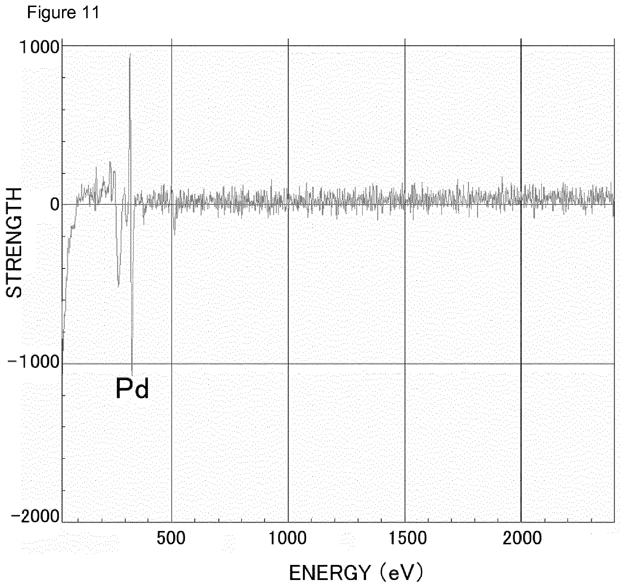

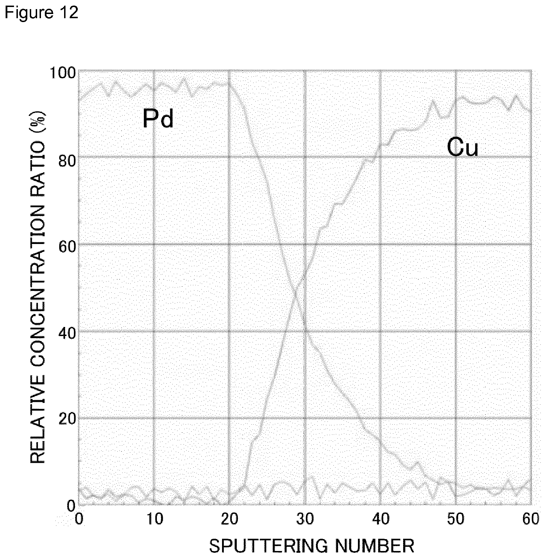

Next, the palladium plating film obtained by the process of Example 1 was subjected to a heat treatment at a temperature of 175°C for 4 hours, and subsequently, the palladium plating film was measured with an Auger electron spectroscopy analysis apparatus. The results of the surface elemental analysis are shown in Figure 11, and the results of the depth direction analysis are shown in Figure 12.

As shown in Figure 11, palladium (Pd) was detected by surface elemental analysis on a surface of the palladium plating film, and copper (Cu) was not detected. Usually, if copper is present on a surface of the plating film, peak of the copper appears at approximately 700 eV. Therefore, it is obvious from Figure 11 that the copper has not been diffused in the palladium plating film.

In addition, as shown in Figure 12, no copper was detected by the depth direction analysis in a region that is spaced by 0.1 µm from the interface between palladium plating film and the atmosphere (in Figure 12, the region with a sputtering number of about 20 times). Therefore, it is also obvious from Figure 12 that the copper has not been diffused in the palladium plating film with a thickness of 0.1 µm. Moreover, it is considered from the results of Figure 11 and Figure 12 that due to the fact that formation of pinholes has been suppressed, and the crystals were fine and dense, the palladium plating film obtained by the processes for carrying out steps S1 to S5 of Example 1 was able to prevent diffusion of the copper.

### [Example 3] (according to the invention)

In the present Example, by carrying out an electroless palladium/gold plating process of the present embodiment, that is, processes (steps S1 to S5) carried out in Example 1 on a copper wiring with L/S=30 µm /30 µm, and subsequently carrying out the electroless gold plating step (S6), palladium/gold plating film was formed. In the electroless palladium plating step (S5), a palladium plating film with a thickness of 0.05 to 0.1 µm was formed. In the electroless gold plating step (S6), a palladium plating film with a thickness of 0.05 to 0.1 µm was formed. Thereafter, the palladium plating film was subjected to a heat treatment at a temperature of 175°C for 4 hours.

### [Comparative Example 2]

In the present Comparative Example, by carrying out an electroless palladium/gold plating process of prior art, that is, the processes (S11 to S15 and S17) carried out in Comparative Example 1 on a copper wiring identical to as in Example 3, and subsequently carrying out electroless gold plating treatment (S18), a palladium/gold plating film was formed. The electroless gold plating treatment (S18) was carried out as was the electroless gold plating step (S6) of Example 3.

### [Reference Example 1]

In the present Reference Example, by carrying out an electroless nickel/gold plating process of prior art, that is, S11 to S15 carried out in Comparative Example 1 on a copper wiring identical to as in Example 3, and subsequently carrying out the electroless nickel plating treatment (S16) and the electroless gold plating treatment (S18), a nickel/gold plating film was formed on the copper wiring. The electroless gold plating treatment (S18) was carried out as was the electroless gold plating treatment (S6) of Example 3. A nickel plating film with a thickness of 5 µm was formed by the electroless nickel plating treatment, and a gold plating film with a thickness of 0.2 µm was formed by the electroless gold plating treatment.

### [Reference Example 2]

In the present Reference Example, by carrying out an electroless nickel/palladium/gold plating process of prior art, that is, S11 to S15 carried out in Comparative Example 1 on a copper wiring identical to as in Example 3, and subsequently, carrying out the electroless nickel plating treatment (S16), the electroless palladium plating treatment (S17) and the electroless gold plating treatment (S18), a nickel/palladium/gold plating film was formed on the copper wiring. The electroless palladium plating treatment (S17) and the electroless gold plating treatment (S18) was carried out as was the electroless palladium plating treatment (S5) and the electroless gold plating treatment (S6) of Example 3. A nickel plating film with a thickness of 5 µm was formed by the electroless nickel plating treatment, and a palladium plating film with a thickness of 0.1 µm was formed by the electroless palladium plating treatment, and a gold plating film with a thickness of 0.1 µm was formed by the electroless gold plating treatment.

### <Evaluation>

After subjecting to a heat treatment to the palladium/gold plating film (palladium 0.1 µm/gold 0.1 µm) obtained by the process of Example 3 at a temperature of 175°C for 4 hours, the palladium plating film was measured with an Auger electron spectroscopy analysis apparatus, and a tendency similar to that in Figure 11 and Figure 12 was observed. In other words, with regard to both of the surface elemental analysis and the depth direction analysis, no copper was detected in the gold plating film. In view of this fact, it is obvious that with regard to the palladium/gold plating film obtained by the electroless palladium/gold plating process of the present embodiment, because in the palladium plating film, pinhole formation is suppressed and the palladium plating film is dense, the diffusion of the copper was able to be prevented, and as a result, the diffusion of the copper into the gold plating film was able to be prevented.

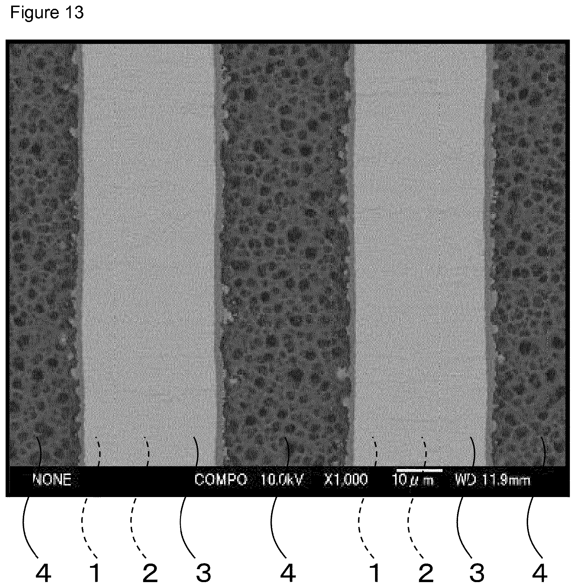

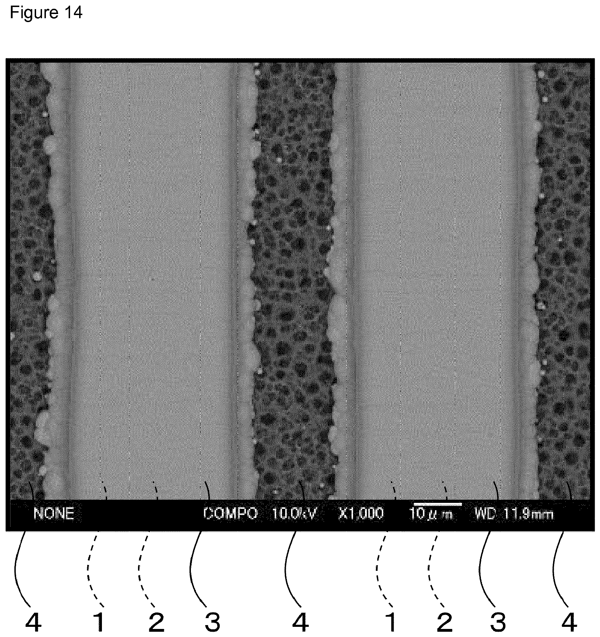

Next, a surface of the palladium/gold plating film obtained by the process of Example 3, and a surface of the nickel/palladium/gold plating film obtained by the process of Reference Example 2 was observed by FE-SEM. Figure 13 shows a SEM image (magnification of 1000 times) of the palladium/gold plating film (palladium 0.1 µm/gold 0.1 µm) obtained by the process of Example 3, and Figure 14 shows a SEM image (magnification of 1000 times) of the nickel/palladium/gold plating film (nickel 5 µm/palladium 0.1 µm/gold 0.1 µm) by obtained the process of Reference Example 2. In addition, Table 2 shows presence or absence of protrusion of gold onto insulating base material in the palladium/gold plating film by obtained the process of Example 3.

It was confirmed from Figure 13 that according to the process of Example 3, there was almost no protrusion of the gold plating film 3 formed on the palladium plating film 2 covering the copper wiring 1 in a transverse direction from the copper wiring 1(left and right directions in the Figure). It is obvious from these results that according to the process of Example 3, the palladium plating film 2 and the gold plating film 3 were formed selectively only on the copper wiring 1. In addition, it is obvious that according to the process of Example 3, due to the fact that the gold plating film 3 was not formed on the insulating base material 4 between the copper wirings 1, a short circuit between the copper wirings 1 can be prevented. In addition, as shown in Table 2, even in each of the palladium/gold plating films that were obtained by the process of Example 3 and that differed in their palladium plating film thickness and their gold plating film thickness, similar results were obtained.

**[Table 2]**

| | Film thickness of palladium/gold plating film | | | |
|---|---|---|---|---|
| | Pd: 0.05 µm | Pd: 0.05 µm | Pd: 0.1 µm | Pd: 0.1 µm |
| | Au: 0.05 µm | Au: 0.1 µm | Au: 0.05 µm | Au: 0.1 µm |
| Example 3 | No Au Protrusion | No Au Protrusion | No Au Protrusion | No Au Protrusion |

On the other hand, it was confirmed from Figure 14 that according to the process of Reference Example 2, a portion of the gold plating film 3 formed on the palladium plating film 2 covering the copper wiring 1 was protruding in a transverse direction from the copper wiring 1. It is obvious from these results that according to the process of Reference Example 2, the gold plating film 3 have been formed not only on the copper wiring 1 but also on the insulating base material 4 between the copper wirings 1, and the copper wirings 1 may undergo a short circuit.

Next, after subjecting to a heat treatment to the palladium/gold plating films with various film thicknesses obtained by the processes of Example 3 and Comparative Example 2 at a temperature of 175°C for 4 hours, a gold wire with a wiring diameter of 25 µm was connected to a surface of the gold plating film of each plating film by a wire bonding apparatus. Subsequently, connection strength when each metal wire was pulled by a pull tester, that is, wire bonding strength was measured. The results are shown in Table 3. Assessment criteria in Table 3 are as follows.

Good ... bonding connection is good, and pull strength is good.

Poor ... bonding connection is impossible, or pull strength is not measurable.

**[Table 3]**

| | Film thickness of palladium/gold plating film | | | |
|---|---|---|---|---|
| | Pd: 0.05 µm | Pd: 0.05 µm | Pd: 0.1 µm | Pd: 0.1 µm |
| | Au: 0.05 µm | Au: 0.1 µm | Au: 0.05 µm | Au: 0.1 µm |
| Example 3 | Good | Good | Good | Good |
| Comparative Example 2 | Poor | Good | Good | Good |

As shown in Table 3, with regard to the palladium/gold plating film obtained by the process of Example 3, regardless of the film thicknesses of the palladium plating film and the gold plating film good results were obtained in each case. On the other hand, with regard to the palladium/gold plating film obtained by the process of Comparative Example 2, good results were not obtained when both of the palladium plating film and the gold plating film were of 0.05 µm.

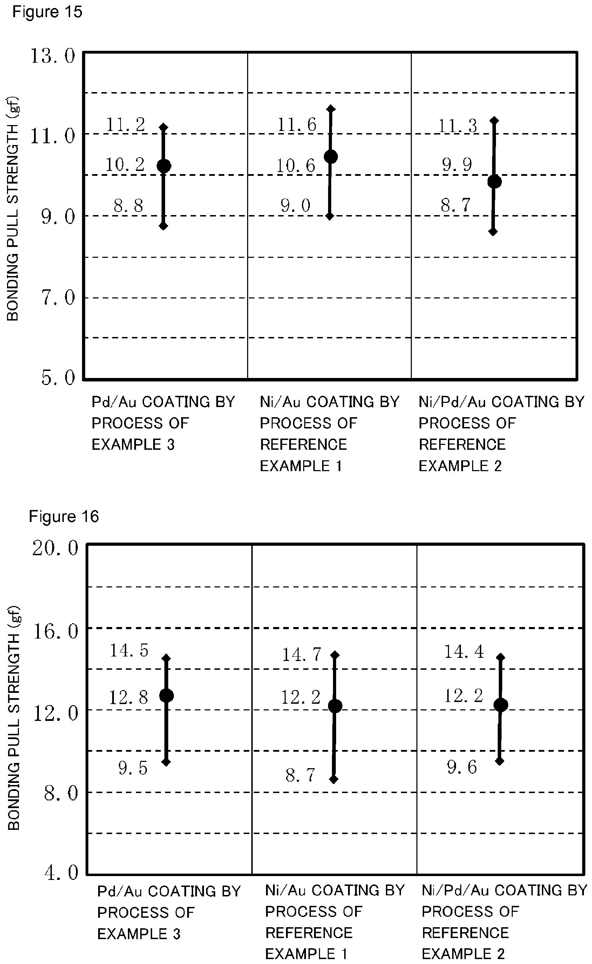

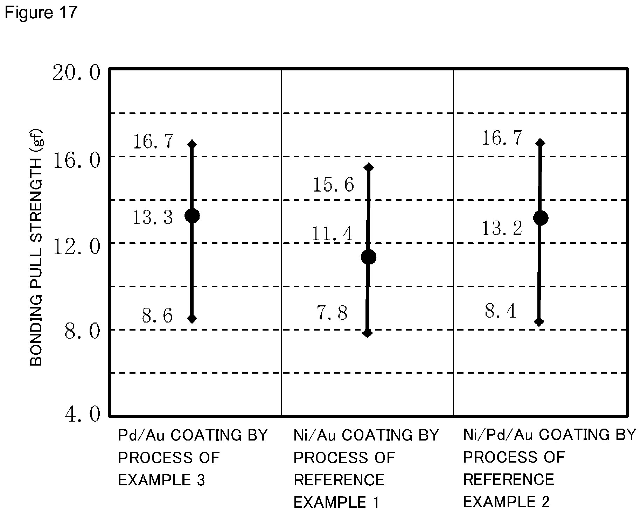

Next, after subjecting to the above-described heat treatment to the palladium/gold plating film obtained by the process of Example 3 (palladium film with a thickness of 0.1 µm, a gold film with a thickness of 0.1 µm, total film thickness of 0.2 µm), the nickel/gold plating film obtained by the process of Reference Example 1 (a nickel film with a thickness of 0.5 µm, a gold film with a thickness of 0.3 µm, total film thickness of 0.8 µm), and the nickel/palladium/gold plating film obtained by the process of Reference Example 2 (a nickel film with a thickness of 0.5 µm, a palladium film with a thickness of 0.1 µm, a gold film with a thickness of 0.1 µm, total film thickness of 0.7 µm), a metal wire was connected to a surface of the gold plating film of each of the plating film, and the wire bonding strength was measured. The number of samples was 25. As metal wires, a gold wire with a wiring diameter of 25 µm, a silver wire with a wiring diameter of 25 µm, and a copper wire with a wiring diameter of 25 µm were used. Figure 15 shows the wire bonding strength in the case of using the gold wire, an Figure 16 shows wire bonding strength in the case of using the silver wire, and Figure 17 shows the wire bonding strength in the case of using the copper wire.

It is obvious from Figure 15 that when compared to that of the nickel/gold plating film obtained by the process of Reference Example 1, although the total film thickness of the palladium/gold plating film obtained by the process of Example 3 is one quarter, the mean value of the wire bonding strength of the palladium/gold plating film in the case of using the gold wire is at a comparable level. In addition, it is obvious that, when compared to the nickel/palladium/gold plating film obtained by the process of Reference Example 2, with regard to the palladium/gold plating film obtained by the process of Example 3, the mean value of the wire bonding strength in the case of using the gold wire is excellent although the nickel plating film is not present.

It is obvious from Figure 16 and Figure 17 that when compared to the nickel/gold plating film obtained by the process of Reference Example 1 and the nickel/palladium/gold plating film obtained by the process of Reference Example 2, with regard to the palladium/gold plating film obtained by the process of Example 3, the mean values of the wire bonding strength in the case of using the silver wire and wire bonding strength in the case of using the copper wire are excellent.

It is obvious from the above description that according to the electroless palladium/gold plating process of Example 3, the palladium/gold plating film having a connection strength equivalent to or superior to that of the nickel/gold plating film and the nickel/palladium/gold plating film can be formed. In addition, it is obvious that according to the electroless palladium/gold plating process of Example 3, a palladium/gold plating film capable of ensuring a connection strength even in the case of a small plating film thickness can be formed.

In addition, it is considered from these results that in the art where a nickel/gold plating film or a nickel/palladium/gold plating film of prior art is used, it is possible to replace the nickel/gold plating film or the nickel/palladium/gold plating film of prior art with a palladium/gold plating film formed by an electrolytic palladium/gold plating process of the present embodiment.

### [Industrial Applicability]

As described above, according to electroless palladium/gold plating process of the present invention, the surface electric potential of the copper is adjusted by a surface electric potential adjusting treatment to be at an electric potential that leads to easy precipitation of palladium, and therefore, a palladium catalyst adsorption treatment carried out in the electroless palladium/gold plating process disclosed in Patent Document 1 can be rendered unnecessary. In addition, even in a case where a plating target is a compact sized single electrode or a wiring with a narrow L/S, it is possible to form a palladium/gold plating film selectively only on the copper without the plating film being formed on the insulating base material. Therefore, it is possible to prevent a short circuit of the copper wirings.

In addition, according to the electroless palladium/gold plating process of the present invention, it is possible to obtain a good plating film, even in a case where both of the film thicknesses of the palladium plating films and the gold plating films are made as mall as approximately 0.5 µm. Therefore, this can contribute to reduction in the layer thickness of a printed circuit board on which a palladium/plating film is formed, and the like.

In addition, the palladium/plating films obtained by the electroless palladium/gold plating process of the present invention have connection strength that is equivalent to or superior to that of the nickel/gold plating films and the nickel/palladium/gold plating films obtained by the electroless plating process of prior art. In view of this fact, in the art where a nickel/gold plating film or a nickel/palladium/gold plating film of prior art is used, it is possible to replace the nickel/gold plating film or the nickel/palladium/gold plating film of prior art with a palladium/gold plating film formed by the electrolytic palladium/gold plating process of the present embodiment.

### [Reference Sings List]

- 1: Copper
- 2: Palladium plating film
- 3: Gold plating film
- 4: Insulating base material

## Claims

1. An electroless palladium/gold plating process for forming a palladium plating film directly on copper of an insulating base material with a surface on which the copper has been disposed and subsequently forming a gold plating film, by electroless plating treatments, comprising:
a step of carrying out a copper surface electric potential adjusting treatment by immersing the insulation base material with a surface on which the copper has been disposed in a sulfur-containing aqueous solution containing one or more sulfur compounds selected from the group consisting of a thiosulfuric acid salt and a thiol;
a step of carrying out an electroless palladium plating treatment on the insulating base material in which the surface electric potential of the copper has been adjusted to form a palladium plating film directly on the copper; and
a step of carrying out an electroless gold plating treatment on the insulating base material in which the palladium plating film has been formed directly on the copper to form a gold plating film on the palladium plating film.

2. The electroless palladium/gold plating process according to claim 1, wherein the thiosulfuric acid salt is sodium thiosulfate or potassium thiosulfate.

3. The electroless palladium/gold plating process according to claim 1 or 2, wherein the thiol is one or more selected from the group consisting of thiomalic acid, thiouracil and thiourea.

4. The electroless palladium/gold plating process according to any one of claims 1 to 3, wherein the sulfur-containing aqueous solution contains a palladium compound at a concentration range of 10 mg/L or less.

5. The electroless palladium/gold plating process according to any one claims 1 to 4, comprising, before the step of carrying out a surface electric potential adjusting treatment, a step of carrying out a degreasing treatment by immersing the insulating base material with a surface on which the copper has been disposed in a neutral degreasing solution,
wherein the neutral degreasing solution contains 20 to 40 g/L of thiodiglycolic acid, 1 to 5 g/L of sodium gluconate, and 0.05 to 0.1 g/L of a nonionic surfactant and pH of the neutral degreasing solution is 5.0 to 7.0.

6. The electroless palladium/gold plating process according to any one of claims 1 to 5, comprising, before the step of carrying out a surface electric potential adjusting treatment, a step of carrying out a copper oxide film removing treatment by immersing the insulating base material with a surface on which the copper has been disposed in a copper oxide film removing solution,
wherein the copper oxide film removing solution contains 2.5 to 12.5 g/L of thioglycol and 1.25 to 2.5 g/L of a nonionic surfactant, and pH of the copper oxide film removing solution is 5.0 to 7.0.

7. The electroless palladium/gold plating process according to any one of claims 1 to 6, wherein the electroless palladium plating treatment is carried out by a reduction type plating.

8. The electroless palladium/gold plating process according to any one of claims 1 to 7, wherein the electroless gold plating treatment is carried out by a reduction type plating.

## Patentansprüche

1. Ein stromloses Palladium/Gold-Plattierungsverfahren zur Bildung eines Palladium-Plattierungsfilms direkt auf Kupfer eines isolierenden Grundmaterials mit einer Oberfläche, auf der das Kupfer angeordnet wurde, und anschließende Bildung eines Gold-Plattierungsfilms durch stromlose Plattierungsbehandlungen, umfassend:
einen Schritt der Durchführung einer Behandlung zur Einstellung des elektrischen Potentials der Kupferoberfläche durch Eintauchen des isolierenden Grundmaterials mit einer Oberfläche, auf der das Kupfer angeordnet wurde, in eine schwefelhaltige wässrige Lösung, welche eine oder mehrere Schwefelverbindungen enthält, ausgewählt aus der Gruppe bestehend aus einem Thioschwefelsäuresalz und einem Thiol;
einen Schritt der Durchführung eines stromlosen Palladium-Plattierungsverfahrens auf dem isolierenden Grundmaterial, bei welchem das elektrische Potential der Oberfläche des Kupfers eingestellt wurde, um einen Palladium-Plattierungsfilm direkt auf dem Kupfer zu bilden; und
einen Schritt der Durchführung eines stromlosen Gold-Plattierungsverfahrens auf dem isolierenden Grundmaterial, bei welchem der Palladium-Plattierungsfilm direkt auf dem Kupfer gebildet wurde, um einen Gold-Plattierungsfilm auf dem Palladium-Plattierungsfilm zu bilden.

2. Das stromlose Palladium/Gold-Plattierungsverfahren gemäß Anspruch 1, wobei das Thioschwefelsäuresalz Natriumthiosulfat oder Kaliumthiosulfat ist.

3. Das stromlose Palladium/Gold-Plattierungsverfahren gemäß Anspruch 1 oder 2, wobei das Thiol eines oder mehrere, ausgewählt aus der Gruppe bestehend aus Thioäpfelsäure, Thiouracil und Thioharnstoff, ist.

4. Das stromlose Palladium/Gold-Plattierungsverfahren gemäß einem der Ansprüche 1 bis 3, wobei die schwefelhaltige wässrige Lösung eine Palladiumverbindung in einem Konzentrationsbereich von 10 mg/l oder weniger enthält.

5. Das stromlose Palladium/Gold-Plattierungsverfahren gemäß einem der Ansprüche 1 bis 4, umfassend, vor dem Schritt der Durchführung einer Behandlung zur Einstellung des elektrischen Potentials der Oberfläche, einen Schritt der Durchführung einer Entfettungsbehandlung mittels Eintauchen des isolierenden Grundmaterials mit einer Oberfläche, auf welcher das Kupfer aufgebracht wurde, in eine neutrale Entfettungslösung,
wobei die neutrale Entfettungslösung 20 bis 40 g/l Thiodiglycolsäure, 1 bis 5 g/l Natriumgluconat und 0,05 bis 0,1 g/l eines nicht-ionischen oberflächenaktiven Mittels enthält und der pH-Wert der neutralen Entfettungslösung 5,0 bis 7,0 beträgt.

6. Das stromlose Palladium/Gold-Plattierungsverfahren gemäß einem der Ansprüche 1 bis 5, umfassend, vor dem Schritt der Durchführung einer Behandlung zur Einstellung des elektrischen Potentials der Oberfläche, einen Schritt des Durchführens einer Behandlung zur Entfernung eines Kupferoxidfilms mittels Eintauchen des isolierenden Grundmaterials mit einer Oberfläche, auf welcher das Kupfer aufgebracht wurde, in eine Lösung zur Entfernung des Kupferoxidfilms,
wobei die Lösung zur Entfernung des Kupferoxidfilms 2,5 bis 12,5 g/l Thioglycol und 1,25 bis 2,5 g/l eines nicht-ionischen oberflächenaktiven Mittels enthält und der pH-Wert der Lösung zur Entfernung des Kupferoxidfilms 5,0 bis 7,0 beträgt.

7. Das stromlose Palladium/Gold-Plattierungsverfahren gemäß einem der Ansprüche 1 bis 6, wobei die stromlose Palladium-Plattierungsbehandlung mittels Plattierung vom Reduktionstyp durchgeführt wird.

8. Das stromlose Palladium/Gold-Plattierungsverfahren gemäß einem der Ansprüche 1 bis 7, wobei die stromlose Gold-Plattierungsbehandlung mittels Plattierung vom Reduktionstyp durchgeführt wird.

## Revendications

1. Procédé de placage de palladium/or autocatalytique pour former un film de placage de palladium directement sur le cuivre d'un matériau de base isolant ayant une surface sur laquelle le cuivre a été disposé et ensuite former un film de placage d'or, par des traitements de placage autocatalytique, comprenant :
une étape de mise en œuvre d'un traitement d'ajustement de potentiel électrique de surface du cuivre par immersion du matériau de base isolant avec une surface sur laquelle le cuivre a été disposé dans une solution aqueuse contenant du soufre contenant un ou plusieurs composés soufrés choisis dans le groupe constitué par un sel d'acide thiosulfurique et un thiol ;
une étape de mise en œuvre d'un traitement de placage de palladium autocatalytique sur le matériau de base isolant, dans laquelle le potentiel électrique de surface du cuivre a été ajusté pour qu'un film de placage de palladium se forme directement sur le cuivre ; et
une étape de mise en œuvre d'un traitement de placage d'or autocatalytique sur le matériau de base isolant, dans laquelle le film de placage de palladium a été formé directement sur le cuivre, pour qu'un film de placage d'or se forme sur le film de placage de palladium.

2. Procédé de placage de palladium/or autocatalytique selon la revendication 1, dans lequel le sel d'acide thiosulfurique est le thiosulfate de sodium ou le thiosulfate de potassium.

3. Procédé de placage de palladium/or autocatalytique selon la revendication 1 ou 2, dans lequel le thiol est un ou plusieurs choisis dans le groupe constitué par l'acide thiomalique, le thiouracile et la thiourée.

4. Procédé de placage de palladium/or autocatalytique selon l'une quelconque des revendications 1 à 3, dans lequel la solution aqueuse contenant du soufre contient un composé de palladium à une gamme de concentrations de 10 mg/l ou moins.

5. Procédé de placage de palladium/or autocatalytique selon l'une quelconque des revendications 1 à 4, comprenant, avant l'étape de mise en œuvre d'un traitement d'ajustement de potentiel électrique de surface, une étape de mise en œuvre d'un traitement de dégraissage par immersion dans une solution de dégraissage neutre du matériau de base isolant avec une surface sur laquelle le cuivre a été disposé,
dans lequel la solution de dégraissage neutre contient 20 à 40 g/l d'acide thiodiglycolique, 1 à 5 g/l de gluconate de sodium, et 0,05 à 0,1 g/l d'un tensioactif non-ionique, et le pH de la solution de dégraissage neutre est de 5,0 à 7,0.

6. Procédé de placage de palladium/or autocatalytique selon l'une quelconque des revendications 1 à 5, comprenant, avant l'étape de mise en œuvre d'un traitement d'ajustement de potentiel électrique de surface, une étape de mise en œuvre d'un traitement d'élimination de film d'oxyde de cuivre par immersion dans une solution d'élimination de film d'oxyde de cuivre du matériau de base isolant avec une surface sur laquelle le cuivre a été disposé,
dans lequel la solution d'élimination de film d'oxyde de cuivre contient 2,5 à 12,5 g/l de thioglycol et 1,25 à 2,5 g/l d'un tensioactif non-ionique, et le pH de la solution d'élimination de film d'oxyde de cuivre est de 5,0 à 7,0.

7. Procédé de placage de palladium/or autocatalytique selon l'une quelconque des revendications 1 à 6, dans lequel le traitement de placage de palladium autocatalytique est mis en œuvre par un placage du type par réduction.

8. Procédé de placage de palladium/or autocatalytique selon l'une quelconque des revendications 1 à 7, dans lequel le traitement de placage d'or autocatalytique est mis en œuvre par un placage du type par réduction.
